# EUROPÄISCHE PATENTSCHRIFT

(11) **EP 1 595 266 B1**
(45) Veröffentlichungstag und Bekanntmachung des Hinweises auf die Patenterteilung: **17.05.2006**
(21) Anmeldenummer: 04708313.4
(22) Anmeldetag: 05.02.2004
(51) Int. Cl.: H01B 1/04, H01L 29/12, H01L 21/02

(54) **QUANTENPUNKT AUS ELEKTRISCH LEITENDEM KOHLENSTOFF, VERFAHREN ZUR HERSTELLUNG UND ANWENDUNG**
QUANTUM POINT MADE OF ELECTRICALLY CONDUCTING CARBON, PRODUCTION METHOD, AND APPLICATION
POINT QUANTIQUE CONSTITUE DE CARBONE ELECTRO-CONDUCTEUR, SON PROCEDE DE PRODUCTION ET SON UTILISATION

(30) Priorität: 08.02.2003 DE 10306076
(43) Veröffentlichungstag der Anmeldung: 16.11.2005
(73) Patentinhaber: Hahn-Meitner-Institut Berlin GmbH, 14109 Berlin (DE)
(72) Erfinder: WEIDINGER, Alois, 14129 Berlin (DE); HOFSÄSS, Hans, 37073 Göttingen (DE); KRAUSER, Johann, 12161 Berlin (DE); MERTESACKER, Bernd, 13503 Berlin (DE); ZOLLONDZ, Jens-Hendrik, 12169 Berlin (DE)
(74) Vertreter: Rudolph, Margit
(86) Internationale Anmeldenummer: PCT/DE2004/000231
(87) Internationale Veröffentlichungsnummer: WO 2004/070735

(56) Entgegenhaltungen:
- WO-A-00/52725
- POSTMA H W: "CARBON NANOTUBE SINGLE-ELECTRON TRANSISTORS AT ROOM TEMPERATURE" SCIENCE, AMERICAN ASSOCIATION FOR THE ADVANCEMENT OF SCIENCE,, US, Bd. 293, 6. Juli 2001 (2001-07-06), Seiten 76-79, XP001060212 ISSN: 0036-8075
- JAPANESE JOURNAL OF APPLIED PHYSICS, Bd. 37, 1. April 1998 (1998-04-01), Seiten 423-425, XP002286630 ROOM TEMPERATURE OPERATION OF AMORPHOUS CARBON-BASED SINGLE-ELECTRON TRANSISTORS FABRICATED BY BEAM-INDUCED DEPOSITION TECHNIQUES

## Beschreibung

Die Erfindung bezieht sich auf einen Quantenpunkt aus elektrisch leitendem Kohlenstoff, auf ein Verfahren zu seiner Herstellung und auf eine Anwendung.

Bei Objekten mit Abmessungen von nur einigen Nanometern, sogenannte Quanten- oder Nanopunkte oder -inseln, ist die Bewegungsfreiheit der Elektronen in allen drei Raumrichtungen eingeschränkt ("nulldimensionales System"). Quantenpunkte, die in der Hauptsache Anwendung in der Nanooptik und der Nanoelektronik finden, weisen ein diskretes Energiespektrum auf und zeigen in mancher Hinsicht ein den Atomen ähnliches Verhalten. Im Gegensatz zu den Atomen kann jedoch auf die Größe und die elektronische Struktur Einfluss genommen werden. Wegen der geringen elektrischen Kapazität der Quantenpunkte erfordert das Hinzufügen eines weiteren Elektrons ("Einzel-Elektron-Tunneln") zu den bereits im Quantenpunkt vorhandenen einen bestimmten Energieaufwand im Bereich von einigen 10 meV bis einigen 100 meV ("Coulomb-Blockade"). Dieser Effekt führt zu einer Quantisierung des Stromflusses über den Quantenpunkt. Der Strom als Funktion der angelegten Spannung steigt in Stufen an respektive kann über diese gesteuert werden. Größe und Form der Quantenpunkte hängen vom Herstellungsverfahren und den verwendeten Materialien ab.

Allgemein bekannt sind Quantenpunkte aus unterschiedlichen Halbleitermaterialien und aus Kohlenstoff. Aus der **Veröffentlichung I** von J.-Y. Park et al. "Electrical cutting and nicking of carbon nanotubes using an atomic force microscope" (Applied Physics Letters, Volume 80, Number 23 (10.06.2003), pp. 4446-4448) ist die relativ aufwändige Herstellung von einzelnen Quantenpunkten aus vorgeformten Nanoröhren aus halbleitendem oder metallischem Kohlenstoff durch deren Abschneiden oder Abknicken bekannt. Aus der japanischen Patentzusammenfassung der **JP 2002217400 A** sind halbrunde Quantenpunkte mit fullerenartiger Struktur bekannt, die in eng benachbarter Vielzahl auf einem Siliziumsubstrat mit einer Kohlenstoffoberfläche im Vakuum unter Wärmezufuhr durch Agglomeration hergestellt werden. Eine gezielte Herstellung einzelner Quantenpunkte durch das selbstorganisierte Aufwachsen ist sehr schwierig.

Quantenpunkte können in vielfältiger Weise realisiert werden. Zu den bekannten Herstellungsverfahren von Quantenpunkten aus Halbleitermaterialien zählen das Ionenstrahlsputtern, die mechanisch strukturierende oder lokal oxidierende Nanolithographie mit dem Rasterkraftmikroskop und die Herstellung durch selbstorganisiertes Inselwachstum nach Stranski-Krastanov. Insbesondere ist jedoch die derzeit vorwiegend verwendete Nanolithographie aufgrund der einzuhaltenden äußerst kleinen Dimensionen bis unter 10 nm sehr aufwändig und störanfällig. Desweiteren ist es aus der **DE 198 57 060 A1** bekannt, Quantenpunkte für ein Halbleiterbauteil durch Agglomeration zu erzeugen, indem eine zwischen zwei halbleitenden Isolierschichten angeordnete leitende Halbleiterschicht getempert wird. Dabei kann jedoch wiederum auf die Verteilung der agglomerierten Quantenpunkte kein direkter Einfluss genommen werden.

Quantenpunkte können aufgrund ihrer besonderen physikalischen Eigenheiten zur Herstellung beliebiger nanoelektrischer Strukturen verwendet werden. Als Grundbausteine sind hier der Stromschalter aufgrund der Coulomb-Blockade, durch die bei einer geringen Variation der angelegten Spannung der Strom stufenartig variiert, und der Einzel-Elektron-Transistor (Single-Electron-Transistor SET) aufgrund der Umschaltfähigkeit der Quantenpunkte zwischen Sperr- und Durchlasszustand über eine Steuerelektrode anzusehen. SET sind vielfältig zu verwenden, beispielsweise in Elektrometern, DC-Normalen, Thermometern sowie Logik- und Speicherelementen. Ein guter Überblick über die physikalischen Grundlagen, die Anwendungen und Einsatzmöglichkeiten sowie über die derzeit verwendeten Herstellungsmethoden von SET ist der **Veröffentlichung II** von K. Hofmann und B. Spangenberg "Der "ultimative" Transistor - Traum oder Wirklichkeit ?" (Physikalische Blätter 56 (2000) Nr. 9, pp 45-49) zu entnehmen. Neben metallischen SET, die durch Schrägschattenbedampfung und Elektronenstrahl-Lithographie hergestellt werden, sind in der Hauptsache SET aus Halbleitern bekannt, die mittels Elektronenstrahl-Lithographie und reaktivem Ionenätzen hergestellt werden. Als alternative, technologisch jedoch noch nicht konkret erfasste Ansätze werden SET aus manipulierten Kohlenstoff-Nanoröhrchen oder metallisierten DNA-Strängen genannt.

Vor dem Hintergrund des zuvor gewürdigten Standes der Technik und ausgehend von der zitierten japanischen Patentzusammenfassung der **JP 2002217400 A** als nächstliegendem Stand der Technik für den Quantenpunkt ist es daher die **Aufgabe** der Erfindung, einen Quantenpunkt aus elektrisch leitendem Kohlenstoff mit definierten Dimensionen in einem Bereich von unter 12 nm mit optimalen nanoelektronischen Eigenschaften anzugeben. Desweiteren soll ein Herstellungsverfahren angegeben werden, mit dem in einfacher, genauer und reproduzierbarer Weise einzelne Quantenpunkte herstellbar sind. Darüber hinaus soll der Quantenpunkt nach der Erfindung aufgrund seines Aufbaus und seines Herstellungsprozesses eine besondere Eignung in der Anwendung für einen SET aufzeigen. Die erfindungsgemäße Lösung ist für einen Quantenpunkt aus leitendem Kohlenstoff der eingangs genannten Art gekennzeichnet durch einen eingebetteten Aufbau als zylindrischer Bereich mit graphitartiger Struktur in einer elektrisch isolierenden Kohlenstoffschicht mit diamantartiger Struktur, die zwischen zwei elektrisch isolierenden, diese Eigenschaft auch nach einem lonendurchgang zeigenden Isolierschichten mit für Elektronen durchtunnelbaren Schichtdicken t₁, t₂ angeordnet ist.

Der erfindungsgemäße Quantenpunkt hat eine zylindrische Form und ist damit in seiner Form genau definiert und isoliert. Er besteht aus elektrisch leitendem Kohlenstoff mit graphitartiger Struktur (Graphite Like Carbon GLC), das in elektrisch isolierendem Kohlenstoff mit diamantartiger Struktur (Diamond Like Carbon DLC) eingebettet ist. Damit ist erstmals eine Realisierung eines Quantenpunktes in DLC gegeben, bei dem es sich insbesondere für die nanoelektronischen Bauelemente um ein sehr interessantes Material handelt. Die Höhe h des Quantenpunktes wird durch die Schichtdicke der Kohlenstoffschicht mit diamantartiger Struktur DLC bestimmt, die zwischen den zwei Isolierschichten angeordnet ist. Diese begrenzen somit den Quantenpunkt an seinen Stirnseiten und bilden die Tunnelbarrieren bzw. den Tunnelabstand für die Elektronen von und zum Quantenpunkt. Somit weisen sie solche Schichtdicken auf, dass sie die funktionswesentliche Durchtunnelung von Elektronen zulassen. Der Durchmesser d des Quantenpunkts wird durch die Art der Herstellung und dabei durch den Wirkdurchmesser des umwandelnden Ions bestimmt (s.u.). Bezüglich der Dimensionierung des Quantenpunktes nach der Erfindung ist es vorteilhaft, wenn er einen Durchmesser d von 8 nm und eine Höhe h von 5 nm aufweist. Bevorzugt können auch die Isolierschichten gleiche Schichtdicken t₁, t₂ von 5 nm aufweisen. Zur Funktionserfüllung der Tunnelbarrieren sollten die Schichtdicken t₁ und t₂ der Isolierschichten jedoch nicht wesentlich größer als 5 nm sein.

Die Isolierschichten, die beispielsweise aus Siliziumoxid SiOₓ bestehen können, sind elektrisch isolierend und behalten diese Eigenschaft auch unter oder nach einem Durchgang von Ionen bei. Nach einer vorteilhaften Weiterbildung der Erfindung kann diese Eigenschaft durch Isolierschichten mit einem eingelagerten Zusatzstoff, der deren elektrische Isolationseigenschaft erhält, erreicht werden. Bei dem Zusatzstoff kann es sich bevorzugt um Wasserstoff, Fluor oder Chlor handeln. Es kann beispielsweise eine Wasserstoffdotierung mit einem Anteil von 30 Atomprozent vorgenommen werden. Bei einer Einlagerung eines Zusatzstoffes mit die Isolationseigenschaften der Isolierschichten erhaltenden Eigenschaften kann es sich dann vorteilhafterweise auch bei den Isolierschichten um Kohlenstoffschichten mit diamantartiger Struktur handeln. Diese werden durch die Dotierung mit dem Zusatzstoff dann beim Durchgang von Ionen strukturell nicht in leitende Graphitbereiche umgewandelt. Weiterhin erhält der einzeln verfügbare Quantenpunkt nach der Erfindung eine stabile Basis und eine Kontaktierungsmöglichkeit durch einen Aufbau mit einem elektrisch leitenden Substrat. Dieses kann problemlos auch für den Aufbau anderer nanoelektronischer Komponenten verwendet werden. Eine monolithische Integration des Quantenpunktes nach der Erfindung mit anderen Bauelementen ist damit möglich.

Die mit Nanolithographie hergestellten, bekannten Quantenpunkte haben den Vorteil, dass direkt bei der Herstellung die wesentlichen Anschlusskontakte hergestellt werden können. Bei den bekannten Quantenpunkten aus Kohlenstoff werden zur Kontaktierung vorgefertigte Nanoröhrchen verwendet. Eine Kontaktierung der bekannten Quantenpunkte aus fullerenartigem Kohlenstoff ist nicht bekannt. Dagegen kann der Quantenpunkt nach der Erfindung vorteilhafterweise direkt eigene elektrische Anschlüsse aufweisen. Es ist dann nach einer weiteren Ausführungsform der Erfindung gekennzeichnet durch einen integrierten Aufbau mit zwei elektrisch leitenden Nanodrähten, die als zylindrische Bereiche mit graphitartiger Struktur und zum Quantenpunkt gleichen Durchmessern in jeweils eine weitere elektrisch isolierende Kohlenstoffschicht mit diamantartiger Struktur der Schichtdicken I₁, I₂ ober- und unterhalb der beiden Isolierschichten eingebettet sind. Somit weist der Quantenpunkt nach der Erfindung integrierte und aufgrund des Herstellungsverfahrens (s.u.) korrekt zentrisch positionierte Anschlüsse mit gleichen elektrischen Eigenschaften und gleichem Durchmesser auf, die ihn für eine Verwendung in nanoelektronischen Bauteilen besonders geeignet machen. Bei einer gleichen Schichtdicke der beiden zusätzlichen, strukturell umwandelbaren Kohlenstoffschichten, in die die Nanodrähte eingebettet sind, ergibt sich somit ein direkt anschlussfähiger Quantenpunkt mit symmetrischem Aufbau. Die integrierten Nanodrähte können aber auch unterschiedliche Längen aufweisen und an den jeweiligen Anwendungsfall des Quantenpunkts in ihrer Länge optimal angepasst werden.

Weiter oben wurden bereits bekannte Herstellungsverfahren für Quantenpunkte näher erläutert, die jedoch alle relativ aufwändig in ihrer Durchführung und dabei trotzdem unbefriedigend in der Erzielung der vorgegebenen Dimensionen und Reproduzierbarkeit der Quantenpunkte sind. Das gemäß der **DE 198 57 060 A1** bekannte Verfahren bildet dabei den zum Herstellungsverfahren nach der Erfindung nächstliegenden Stand der Technik. Zur Erzeugung des Quantenpunktes aus elektrischen leitendem Kohlenstoff nach der Erfindung hingegen kann ein besonders einfaches und trotzdem hochgenaues Herstellungsverfahren mit den nachfolgenden Verfahrensschritten besonders vorteilhaft verwendet werden:
- Aufbringen einer unteren elektrisch isolierenden, diese Eigenschaft auch nach einem Ionendurchgang zeigenden Isolierschicht mit einer für Elektronen durchtunnelbaren Schichtdicke t₁ auf ein elektrisch leitendes Substrat,
- Aufbringen einer elektrisch isolierenden Kohlenstoffschicht mit diamantartiger Struktur und sehr geringer, die Höhe des Quantenpunktes festlegenden Schichtdicke h,
- Aufbringen einer oberen elektrisch isolierenden, diese Eigenschaft auch nach einem Ionendurchgang zeigenden Isolierschicht mit einer für Elektronen durchtunnelbaren Schichtdicke t₂,
- Bestrahlung des Schichtenpakets mit einem senkrecht dazu ausgerichteten Ionenstrahl aus schweren Ionen mit einer vorgegebenen Fluenz, die einen ausreichenden Abstand zwischen den einzelnen Durchgangsspuren der Ionen gewährleistet, und mit einer vorgegebenen Energie, die eine für eine in der Durchgangsspur jedes Ions erfolgende Umstrukturierung der elektrisch isolierenden Kohlenstoffschicht mit diamantartiger Struktur in elektrisch leitenden Kohlenstoff mit graphitartiger Struktur hinreichend hohe Energiedeposition gewährleistet, und
- Detektion der hergestellten Quantenpunkte aufgrund ihrer gegenüber der Kohlenstoffschicht mit diamantartiger Struktur erhöhten elektrischen Leitfähigkeit.

Das prinzipielle Verfahren zur Umwandlung einer elektrisch isolierenden Kohlenstoffschicht mit diamantartiger Struktur (DLC) in eine elektrisch leitende Kohlenstoffschicht mit graphitartiger Struktur ist aus dem deutschen Patent **DE 199 10 156 C2** des gleichen Anmelders bekannt. Hierin werden ein Elektronenemitter in Kohlenstoff mit diamantartiger Struktur und ein Verfahren zu dessen Herstellung beschrieben. Der besondere Vorteil des bekannten Verfahrens liegt in der vertikalen Ausrichtung der emittierenden Nanoröhren und in deren statistisch gleichmäßigen Verteilung in der Fläche in Abhängigkeit von der gewählten Fluenz (Anzahl der auftreffenden Ionen/cm²). Dazu wird zunächst auf einem Substrat eine isolierende Schicht mit einer Dicke zwischen 40 nm und 1000 nm aufgebracht, anschließend wird diese Schicht senkrecht zu ihrer Oberfläche mit energiereichen, schweren Ionen homogen bestrahlt, wobei die Ionen eine solche Energie aufweisen, die eine für eine Umstrukturierung der isolierenden Schicht hinreichend hohe Energiedeposition über die gesamte Dicke dieser Schicht gewährleistet, und die Ionen eine Dosis (Fluenz) aufweisen, bei der der mittlere Abstand der statistisch in die isolierende Schicht einschlagenden Ionen zwischen 20 nm und 1000 nm liegt. Dabei werden als energiereiche schwere Ionen Xe-Ionen mit einer Energie von 240 MeV und einer Dosis von 5 x 10¹⁰ Teilchen/cm² verwendet. Als Material für die isolierende Schicht kann diamantartiger Kohlenstoff verwendet werden, das mittels Ionendeposition auf einem dotierten Silizium-Substrat aufgebracht wird und eine Schichtdicke von 100 nm aufweisen kann.

Im Gegensatz dazu wird bei dem erfindungsgemäßen Verfahren nicht eine einzelne, dickere Kohlenstoffschicht, sondern eine alternierende Schichtenabfolge aus wandel- und nicht-wandelbaren elektrisch isolierenden Schichten aufgebracht und anschließend mit einem lonenstrahl gemeinsam durchstrahlt. Dabei kann es sich um einen breiteren lonenstrahl, in dem der mittlere Auftreff-Abstand zwischen den Ionen durch die gewählte Fluenz statistisch festgelegt ist, oder gemäß einer vorteilhaften Weiterbildung des erfindungsgemäßen Herstellungsverfahrens um einen Mikro-Ionenstrahl handeln. Dieser bietet die Möglichkeit, gezielt einzelne Ionenspuren in einem definierten Abstand, z.B. einige Nanometer, zu setzen. Die wandelbare, elektrisch isolierende Kohlenstoffschicht mit diamantartiger Struktur wird in der oder den Durchgangsspuren der Ionen in eine elektrisch leitende Graphitschicht umgewandelt. Die Isolierschichten behalten dabei ihre elektrische Isolationsfähigkeit. Der Durchmesser des herzustellenden Quantenpunktes wird durch die Wahl des Ions, hierbei kann es sich beispielsweise um ein Gold- oder Uran-Ion handeln, festgelegt. Jeder Quantenpunkt wird somit von nur einem Ion erzeugt. Mit dieser einfachen, aber sehr genauen und zuverlässig reproduzierbaren Herstellungsmethode werden ein einzelner oder auch mehrere, ausreichend zueinander beabstandete Quantenpunkte im Schichtenaufbau erzeugt. Das Auffinden des oder der erzeugten Quantenpunkte erfolgt durch Detektion der elektrischen Leitfähigkeit in der Oberfläche des Schichtenpakets. Hierzu kann beispielsweise als Detektor ein Messstromkreis zwischen dem leitenden Substrat des Schichtenpakets (oder einer dort aufgebrachten Flächenelektrode) und der Spitze eines Rasterkraftmikroskops (Atomic-Force-Microscope AFM) angelegt und die Oberfläche des Schichtenpakets mit der AFM-Spitze in hoher Ortsauflösung abgetastet werden. Ein Anstieg der elektrischen Leitfähigkeit zeigt den oder die erzeugten Quantenpunkte an. Es können danach ein oder mehrere bevorzugte Quantenpunkte ausgewählt und elektrisch kontaktiert werden.

Die Beständigkeit der elektrisch isolierenden Schichten beim lonendurchgang ist wesentlich für die einfache Erzeugbarkeit des Quantenpunktes nach der Erfindung. Nach einer Fortführung des Herstellungsverfahrens nach der Erfindung ist es dafür vorteilhaft, wenn während des Aufbringens der Isolierschichten eine Zufuhr eines gasförmigen Zusatzstoffes erfolgt, der die elektrische Isolationseigenschaft der Isolierschichten erhaltende Eigenschaften aufweist. Bei dem gasförmigen Zusatzstoff kann es sich bevorzugt um Wasserstoff-, Chlor oder Fluorgas handeln, das beispielsweise in die Produktionskammer eingeleitet wird. Durch die Einlagerung des Zusatzstoffes wird die dauerhafte elektrische Isolationswirkung der Isolierschichten bewirkt, sodass diese nun ebenfalls auch aus Kohlenstoff mit diamantartiger Struktur bestehen können. Durch die gleiche Materialwahl für alle Schichten wird der Herstellungsprozess noch weiter vereinfacht. Das temporäre Einleiten des gasförmigen Zusatzstoffes während der Herstellung der Isolierschichten in die Produktionskammer stellt kein technologisches Problem dar und ist einfach und genau steuerbar. Somit kann letztendlich durch die Wahl des jeweiligen Anfangszeitpunkts und der Länge der Einleitung des gasförmigen Zusatzstoffes die Schichtenabfolge aus dauerhaft isolierenden Schichten und umwandelbaren Schichten zur Herstellung des Quantenpunkts und der kontaktierenden Nanodrähte und die jeweiligen Schichthöhen während des fortlaufenden Aufbringens von Kohlenstoff mit diamantartiger Struktur festgelegt werden. Zum Aufbringen können verschiedene Verfahren, bevorzugt die Deposition von Kohlenstoff-Ionen in einem Energieintervall von 50 eV bis 200 eV bei Raumtemperatur verwendet werden. Das Aufbringen der Isolierschichten kann durch Aufdampfen aus der Gasphase erfolgen, insbesondere, wenn sie nicht aus Kohlenstoff bestehen. Andere Abscheideverfahren sind ebenfalls anwendbar.

Die elektrische Kontaktierung stellt eine grundsätzliche Schwierigkeit bei der Nutzung von Quantenpunkten aufgrund ihrer kleinen Abmessungen dar. Der Quantenpunkt nach der Erfindung kann deshalb vorteilhafterweise bereits integrierte Nanodrähte als Anschlussdrähte aufweisen. Zu deren Herstellung ist dafür gemäß einer vorteilhaften Weiterbildung im erfindungsgemäßen Verfahren ein dem Aufbringen der Isolierschichten vor- und nachgelagertes Aufbringen jeweils einer dickeren Kohlenstoffschicht mit diamantartiger Struktur der Schichtdicken I₁, I₂ vorgesehen. Bei der Bestrahlung mit dem Ionenstrahl werden die Durchgangsspuren dann in leitende Bereiche mit graphitartiger Struktur umgewandelt. Somit findet der gleiche Herstellungsprozess wie bei dem Quantenpunkt statt. Der Unterschied liegt in der Schichtdimensionierung. Durch die größeren Schichtdicken I₁, I₂ der zusätzlich abgeschiedenen Kohlenstoffschichten entstehen keine weiteren Quantenpunkte mehr, sondern längliche Nanodrähte, deren gleiche oder unterschiedliche Längen durch die Schichtdicken I₁, I₂ der zusätzlichen Kohlenstoffschichten gegeben sind. Die Nanodrähte sind bei der Erfindung aber per Herstellungsprinzip direkt mit dem Quantenpunkt in einer vertikalen Linie versatzfrei ausgerichtet und kontaktiert. Die beiden Isolierschichten weisen dafür solche Schichtdicken t₁, t₂ auf, dass sie von Elektronen durchtunnelt werden können (beispielsweise 5 nm). Die Durchdringung des gesamten Schichtpaketes bis zu einigen Mikrometer Dicke mit dem hochenergetischen Ionenstrahl ist gewährleistet.

Durch die versatzfreie Verbindung zwischen dem Quantenpunkt und den Nanodrähten aufgrund der in-situ-Herstellung mit einem Ionenstrahl bietet der Quantenpunkt nach der Erfindung beste Voraussetzungen für eine äußere elektrische Kontaktierung gemäß einer weiteren Erfindungsfortführung und damit zu einer effizienten Anwendung in einem Nutzkreis. Bezüglich der äußeren elektrischen Kontaktierung gibt es verschiedene Realisierungsmöglichkeiten. Es können beispielsweise mit dem Lithographieverfahren dünne, ein bis mehrere µm breite Leiterbahnen auf das Substrat aufgebracht werden. Anschließend wird das Schichtpaket abgeschieden. Auf die oberste Schicht werden dann senkrecht zu den unteren Leiterbahnen weitere dünne Leiterbahnen aufgebracht. An den virtuellen Kreuzungspunkten wird anschließend durch gezielte Ionenbestrahlung jeweils ein Quantenpunkt gesetzt. Dies kann durch einen Mikro-Ionenstrahl (Weiterschaltung des Mikro-Ionenstrahls von Kreuzungspunkt zu Kreuzungspunkt) oder durch Ausnutzung der statistischen Verteilung der von einem Ionenstrahl induzierten Quantenpunkte erfolgen. Bei einer statistischer Verteilung der Ionen über die Fläche erhält man bei geeigneter Wahl der Fluenz pro Kreuzungspunkt entweder keinen oder einen oder zwei usw. Quantenpunkte. Auf Grund des Widerstandes im Stromkreis kann entschieden werden, wie viele Quantenpunkte in einen Umfeldkreis vorhanden sind. Eine Beschränkung auf einen Umfeldkreis mit nur einem Quantenpunkt kann dann erfolgen. Alternativ zu der Methode mit den virtuell gekreuzten Leiterbahnen kann auch eine AFM-Spitze den einen Kontakt und das leitende Substrat den anderen Kontakt bilden. Der Messkreis zur Detektion des Quantenpunktes ist dann gleichzeitig der Kontaktierungskreis. Um die Kapazität des elektrischen Kreises gering zu halten, werden bevorzugt mikrostrukturierte Zuleitungen auf dem Substrat gewählt.

Von besonderem Vorteil ist es auch, wenn gemäß einer nächsten Erfindungsfortführung im Herstellungsverfahren mit einer n-fachen Wiederholung des Schichtenaufbaus zur Erzeugung von n vertikal in einer Linie angeordneten Quantenpunkten erfolgt, wobei zwischen diesen zumindest eine Isolationsschicht der Schichtdicke tₙ aufgebracht wird. Dadurch entsteht eine Vielzahl von Quantenpunkten, die wie an einer Perlenkette aneinander gereiht sind. Zwischen den Quantenpunkten befindet sich immer eine Isolationsschicht der Schichtdicke tₙ, die konstant oder auch veränderlich sein kann. Gegebenenfalls können auch Leiterstücke aus Kohlenstoff mit diamantartiger Struktur zwischen die einzelnen Quantenpunkt eingefügt werden. Dazu werden zusätzliche DLC-Schichten wie bei der Herstellung der Nanodrähte zur Kontaktierung eines einzelnen Quantenpunkts in das Schichtenpaket an die entsprechenden Stellen eingebracht. Je nach der Wiederholungsanzahl der einen Quantenpunkt definierenden Schichtfolge können somit eine entsprechende Anzahl von vertikal versatzfrei in einer Linie liegenden Quantenpunkte mit einem einzelnen Ion erzeugt werden. Vorteil dieser vertikalen Anordnung mehrerer Quantenpunkte übereinander ist deren integrierte elektrische Verbindung, die beim Ionendurchgang automatisch in den zusätzlichen Kohlenstoffschichten aus DLC hervorgerufen wird. Eine Kombination der vertikalen mit der horizontalen Ausbildung von Quantenpunkten führt schließlich zu einer räumlichen Anordnung der Quantenpunkte. Eine getrennte oder gemeinsame Nutzung der erzeugten Quantenpunkte in der Fläche unter entsprechender Kontaktierung ist hier möglich.

Durch die integrierte Kombination des Quantenpunkts mit zwei elektrischen Anschlüssen in Form von Nanodrähten ergibt sich eine neuartiger Aufbau, der gemäß einer besonders bevorzugten Anwendung der Quantenpunkts nach der Erfindung für eine Anwendung in einem Einzel-Elektron-Transistor mit einer elektrischen Kontaktierung der beiden Nanodrähte im Quellen-Senken-Stromkreis und mit einer ringförmigen Steuerelektrode, die konzentrisch zum Quantenpunkt auf der oberen Kohlenstoffschicht mit diamantartiger Struktur angeordnet ist, geeignet ist. Das Kontaktieren der beiden Nanodrähte kann beispielsweise über die bereits weiter oben erwähnte Möglichkeit mit einer AFM-Spitze und einer Kontaktierung des leitenden Substrats oder einer dort aufgebrachten Flächenelektrode erfolgen. Das Aufbringen einer ringförmigen Steuerelektrode kann durch entsprechendes Wegätzen einer beispielsweise vor der Herstellung des Quantenpunkts auf dem Schichtenpaket zusätzlich aufgedampften Metallschicht erfolgen. Über die Orientierung zu den integrierten und in axialer Verlängerung zum Quantenpunkt liegenden Nanodrähten ist ein zentrische Anordnung der ringförmigen Steuerelektrode einfach zu erreichen. Somit steht durch die Verwendung des Quantenpunktes nach der Erfindung erstmals ein SET auf Basis von Kohlenstoff mit diamantartiger Struktur zur Verfügung. Nähere Einzelheiten zu dem SET unter Verwendung des Quantenpunktes nach der Erfindung sind dem speziellen Beschreibungsteil zu entnehmen.

**Ausbildungsformen der Erfindung** werden nachfolgend anhand der schematischen Figuren näher erläutert. Dabei zeigt :
- **Figur 1**: einen Quantenpunkt nach der Erfindung im Querschnitt,
- **Figur 2**: ein dreifaches Schichtenpaket zur Herstellung von drei Quantenpunkten in vertikaler Linie im Querschnitt und
- **Figur 3**: eine Quantenpunkt nach der Erfindung in einer Anwendung als Einzel-Elektron-Transistor im Querschnitt.

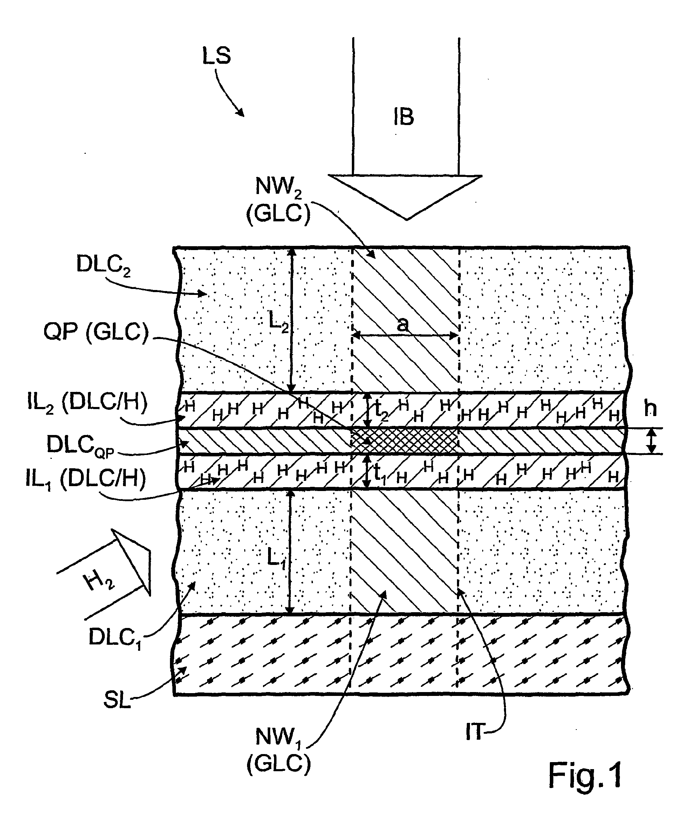

Die **Figur 1** zeigt im Querschnitt ein Schichtenpaket **LS** mit einem Quantenpunkt **QP** aus elektrisch leitendem Kohlenstoff **GLC** mit graphitartiger Struktur. Der Quantenpunkt **QP** ist zylindrisch ausgebildet und in eine elektrisch isolierende Kohlenstoffschicht **DLC**_{**QP**} mit diamantartiger Struktur eingebettet, deren Schichtdicke die Höhe h des Quantenpunkts **QP** festlegt. Die Kohlenstoffschicht **DLC**_{**QP**} wiederum ist zwischen zwei elektrisch isolierenden Isolierschichten **IL**_{**1**}**, IL**_{**2**} angeordnet, die ihre isolierende Eigenschaft auch nach dem Durchgang eines Ions beibehalten. Dies kann beispielsweise durch eine Dotierung mit Wasserstoff **H** in erreicht werden. In diesem Falle können die beiden Isolierschichten **IL**_{**1**}**, IL**_{**2**} verfahrensvereinfachend dann auch aus Kohlenstoff **DLC** mit diamantartiger Struktur bestehen. Im Beispiel weisen sie eine Schichtdicke **t** von 5 nm auf. Aufgebaut ist der Quantenpunkt **QP** auf einem elektrisch leitenden Substrat **SL.** Im gezeigten Ausführungsbeispiel weist der Quantenpunkt **QP** eine Höhe von 5 nm auf, die der Höhe der Kohlenstoffschicht **DLC**_{**QP**} mit diamantartigem Struktur entspricht. Der Durchmesser **d** des Quantenpunktes **QP** wird von dem durchdringenden Ion bestimmt und beträgt im Beispiel 8 nm.

Weiterhin sind in der **Figur 1** zwei integrierte Nanodrähte **NW**_{**1**}**, NW**_{**2**} zu erkennen, die als zylindrische Bereiche aus Kohlenstoff mit graphitartiger Struktur **GLC** und zum Quantenpunkt **QP** gleichen Durchmessern in zwei weitere, dickere elektrisch isolierende Kohlenstoffschichten **DLC**_{**1**}**, DLC**_{**2**} mit diamantartiger Struktur ober- und unterhalb der beiden Isolierschichten **IL**_{**1**}**, IL**_{**2**} eingebettet sind. Dabei weisen die beiden Isolierschichten **IL**_{**1**}**, IL**_{**2**} eine für Elektronen durchtunnelbare Schichtdicke **t** auf, sodass der elektrische Anschluss der beiden Nanodrähte **NW**_{**1**}**, NW**_{**2**} an den Quantenpunkt **QP** gewährleistet ist. Die zylindrischen Nanodrähte **NW**_{**1**}**, NW**_{**2**} weisen gegenüber dem Quantenpunkt **QP** eine erheblich größere Länge I auf und liegen mit diesem genau in einer vertikalen Linie, was sich aus dem unten näher erläuterten Herstellungsverfahren ergibt. Durch die beiden Nanodrähte **NW**_{**1**}**, NW**_{**2**} ist der Quantenpunkt **QP** optimal kontaktiert und kann problemlos in nanoelektronischen Bauelementen weiterverwendet werden.

Anhand des in **Figur 1** dargestellten Schichtenpaket **LS** mit einem Quantenpunkt **QP** und integrierten Nanodrähten **NW**_{**1**}**, NW**_{**2**} nach der Erfindung wird im Folgenden das Herstellungsverfahren nach der Erfindung näher erläutert. Zunächst wird auf das elektrisch leitende Substrat SL, das beispielsweise aus dotiertem Silizium besteht, die untere dickere Kohlenstoffschicht **DCL**_{**1**} mit diamantartiger Struktur beispielsweise durch lonendeposition abgeschieden. Nachdem diese Schicht eine vorgegebene Schichtdicke **I**_{**1**}**,** im Beispiel 20 nm, erreicht hat, wird die untere Isolierschicht **IL**_{**1**}**,** die auch nach dem Durchgang der Ionen isolierend bleibt, mit einer Schichtdicke **t**_{**1**} von 5 nm aufgedampft, sodass sie von Elektronen durchtunnelt werden kann. Zur Aufrechterhaltung der Isolationswirkung unter Ionenbeschuss wird im gezeigten Ausführungsbeispiel während des Aufbringens Wasserstoffgas **H**_{**2**} zugeführt, aus dem sich Wasserstoff **H** in die untere Isolierschicht **IL**_{**1**} homogen mit einem Molekülanteil von beispielsweise bis zu 30 Atomprozent einlagert. Bei dieser Ausführungsform kann auch die untere Isolierschicht **IL**_{**1**} aus Kohlenstoff mit diamantartiger Struktur bestehen. Als nächster Schicht wird eine dünne Kohlenstoffschicht **DLC**_{**QP**} mit diamantartiger Struktur in der gewünschten Höhe **h** des Quantenpunktes **QP**, hier 5 nm, abgeschieden. Darauf wird analog zur unteren Isolierschicht **IL**_{**1**} die obere Isolierschicht **IL**_{**2**} mit in einer Schichtdicke **t**_{**2**} von im Beispiel ebenfalls 5 nm abgeschieden. Abschließend folgt eine obere dickere Kohlenstoffschicht **DLC**_{**2**} der Schichtdicke **I**_{**2**}**,** im Ausführungsbeispiel ebenfalls 20nm, analog zu der unteren, dickeren Kohlenstoffschicht **DLC**_{**1**}**.** Damit ist das Schichtenpaket **LS** zur Herstellung eines oder mehrerer in der mittleren Kohlenstoffschicht **DLC**_{**QP**} angeordneten Quantenpunkten **QP** mit Nanodrähten **NW**_{**1**}**, NW**_{**2**} fertiggestellt.

Als nächster Verfahrensschritt wird das Schichtenpaket **LS** senkrecht zu seiner Oberfläche mit einem Ionenstrahl **IB** bestrahlt. Gezeigt ist eine Ionenspur **IT.** Dabei sind auch Abweichungen des Auftreffwinkels der Ionen tolerierbar. Diese führen zu einer Verzerrung der zylindrischen Form der Quantenpunkte **QP**, die jedoch akzeptabel ist, solange sie deren Funktion nicht beeinträchtigt.

Bei den Ionen kann es sich um Xe-, Au- oder auch U -Ionen handeln, letztere können eine Energie von 1 GeV aufweisen. Bei einem Ionenstrahl mit einer gewählten Fluenz von 1x10⁸ Ionen/cm² weisen die einzelnen Auftrefforte der Ionen einen mittleren Abstand von 1000 nm auf, was einer guten Vereinzelung der Quantenpunkte **QP** entspricht. Die Durchtrittsspur **IT** des lonenstrahls **IB** durch das Schichtenpaket **LS** ist gestrichelt eingezeichnet. Im gezeigten Ausführungsbeispiel ist ein Quantenpunkt **QP** in der Kohlenstoffschicht **DLC**_{**QP**} durch Umwandlung der nichtleitenden diamantartigen Struktur in eine leitende graphitartige Struktur **GLC** durch lonendurchtritt entstanden. Das Auffinden des Quantenpunkts **QP** erfolgt dann im letzten Verfahrensschritt, beispielsweise mittels Detektion der elektrischen Leitfähigkeit mit einer **AFM**-Spitze gegenüber einer flächigen Rückelektrode. Der detektierte Quantenpunkt **QP** kann dann an der Oberfläche des Schichtenpakets **LS** kontaktiert werden.

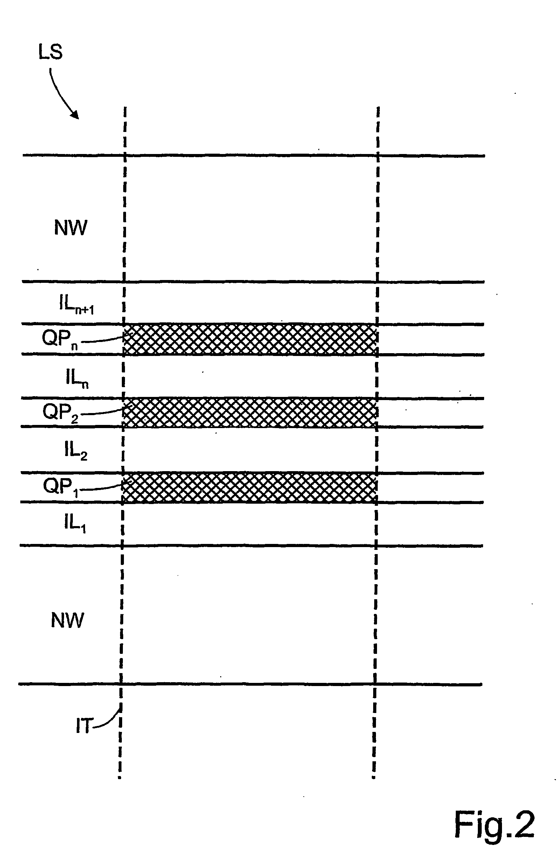

Die **Figur 2** zeigt im Querschnitt einen dreifachen Schichtenaufbau (n=3) des Schichtenpakets **LS** gemäß **Figur 1**, der durch zyklisches Wiederholen des zuvor erläuterten Herstellungsverfahrens nach der Erfindung entsteht. Beim Ionendurchgang entstehen so drei Quantenpunkte **QP,** die versatzfrei vertikal in der Durchtrittsspur **IT** des durchgetretenen Ions übereinander wie Perlen an einer Kette angeordnet sind und durch durchtunnelbare Isolationsschichten **IL** getrennt sind. Je nach Anforderung durch das zu realisierende Bauelement können so viele Quantenpunkte **QP** durch Wiederholung des Schichtenaufbaus vertikal übereinander hergestellt werden. Über Nanodrähte **NW** kann die Reihe aus Quantenpunkten **QP** kontaktiert werden. Zwischen einzelnen Quantenpunkten **QP** können auch kurze Leiterstücke integriert sein (in der Figur 2 nicht weiter dargestellt). Die maximale Ionenenergie stellt die Grenze für die maximale Anzahl der übereinander liegenden Quantenpunkte **QP** bzw. für die maximale Dicke des Schichtenpakets **LS** dar.

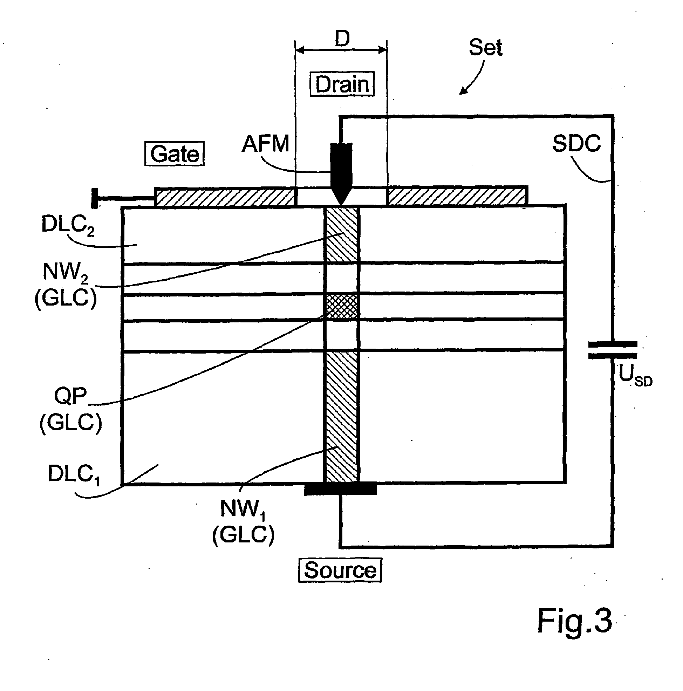

In der **Figur 3** ist im Querschnitt die Verwendung eines Quantenpunktes **QP** nach der Erfindung als Einzel-Elektron-Transistor **SET** dargestellt. Dazu ist der Quantenpunkt **QP** im Quellen-Senken-Stromkreis **SDC** des Einzel-Elektron-Transistor **SET** kontaktiert. Die Kontaktierung erfolgt im gewählten Beispiel über eine **AFM**-Spitze am oberen Nanodraht **NW**_{**1**} (Senke **Drain)** und eine flächige Elektrode **PE** im Bereich des unteren Nanodrahtes **NW**_{**2**} des Quantenpunktes **QP** (Quelle **Source).** Im Senkenbereich ist auf der oberen Kohlenstoffschicht **DLC**_{**2**} mit diamantartiger Struktur eine metallische, ringförmige Steuerelektrode (**Gate**) konzentrisch zum Quantenpunkt **QP** angeordnet. Der Innendurchmesser **D** der Steuerelektrode (**Gate**) beträgt im gewählten Ausführungsbeispiel 100 nm. Durch Veränderung der Steuerspannung an der Steuerelektrode (**Gate**) wird der Stromfluss im Quellen-Senken-Stromkreis **SDC** verändert (**U**_{**SD**}). So können die transistortypischen Stellungen zwischen Sperren und Durchlassen und im Durchlassbereich sogar noch ein abgestufter Stromfluss mit Hilfe eines Quantenpunkts **QP** und dessen elektronenweiser Be- und Entladung erreicht werden.

### Bezugszeichenliste

- **AFM**: Rasterkraftmikroskop
- **DLC**: Kohlenstoffschicht mit diamantartiger Struktur
- **d**: Durchmesser QP
- **D**: Innendurchmesser Gate
- **Drain**: Senke
- **Gate**: Steuerelektrode
- **GLC**: Kohlenstoff mit graphitartiger Struktur
- **h**: Höhe QP, Schichtdicke DLC_{QP}
- **IB**: Ionenstrahl
- **IT**: Durchtrittsspur
- **IL**: Isolierschicht
- **I**_{**1**}**, I**_{**2**}: Schichtdicke von DLC₁, DLC₂
- **LS**: Schichtenpaket
- **NW**: Nanodraht
- **PE**: flächige Elektrode
- **QP**: Quantenpunkt
- **SDC**: Quellen-Senken-Stromkreis
- **SET**: Einzel-Elektron-Transistor
- **SL**: leitendes Substrat
- **Source**: Quelle
- **t**_{**1**}**, t**_{**2**}: Schichtdicke von IL₁, IL₂
- **U**_{**SD**}: Spannung im SDC

## Patentansprüche

1. Quantenpunkt aus elektrisch leitendem Kohlenstoff,
**gekennzeichnet durch** einen eingebetteten Aufbau als zylindrischer Bereich mit graphitartiger Struktur (GLC) in einer elektrisch isolierenden Kohlenstoffschicht (DLC_{QP}) mit diamantartiger Struktur, die zwischen zwei elektrisch isolierenden, diese Eigenschaft auch nach einem lonendurchgang zeigenden Isolierschichten (IL₁, IL₂) mit für Elektronen durchtunnelbaren Schichtdicken t₁, t₂ angeordnet ist.

2. Quantenpunkt nach Anspruch 1,
**gekennzeichnet durch** Isolierschichten (IL₁, IL₂) mit einem eingelagerten Zusatzstoff, der deren elektrische Isolationseigenschaft erhält.

3. Quantenpunkt nach Anspruch 2,
**gekennzeichnet durch** Wasserstoff (H), Fluor (F) oder Chlor (CL) als eingelagerten Zusatzstoff in den Isolierschichten (IL₁, IL₂).

4. Quantenpunkt nach Anspruch 2 oder 3,
**gekennzeichnet durch** Isolierschichten (IL₁, IL₂) aus Kohlenstoff mit diamantartiger Struktur (DLC).

5. Quantenpunkt nach einem der Ansprüche 1 bis 4,
**gekennzeichnet durch**
einen Aufbau mit einem elektrisch leitenden Substrat (SL).

6. Quantenpunkt nach einem der Ansprüche 1 bis 5,
**gekennzeichnet durch** einen Durchmesser d von 8 nm und eine Höhe h von 5 nm und **durch** gleiche Schichtdicken t₁, t₂ der Isolierschichten (IL₁, IL₂) von ebenfalls 5 nm.

7. Quantenpunkt nach Anspruch 6,
**gekennzeichnet durch** einen integrierten Aufbau mit zwei elektrisch leitenden Nanodrähten (NW₁, NW₂), die als zylindrische Bereiche in Kohlenstoff mit graphitartiger Struktur (GLC) und zum Quantenpunkt (QP) gleichen Durchmessern d in jeweils eine weitere elektrisch isolierende Kohlenstoffschicht (DLC₁, DLC₂) mit diamantartiger Struktur der Schichtdicken I₁, I₂ ober- und unterhalb der beiden Isolierschichten (IL₁, IL₂) eingebettet sind.

8. Verfahren zur Herstellung von Quantenpunkten (QP) aus elektrischen leitendem Kohlenstoff, insbesondere nach einem der Ansprüche 1 bis 7, mit den Verfahrensschritten :
• Aufbringen einer unteren elektrisch isolierenden, diese Eigenschaft auch nach einem lonendurchgang zeigenden Isolierschicht (IL₁) mit einer für Elektronen durchtunnelbaren Schichtdicke t₁ auf ein elektrisch leitendes Substrat (SL),
• Aufbringen einer elektrisch isolierenden Kohlenstoffschicht (DLC_{QP}) mit diamantartiger Struktur und sehr geringer, die Höhe des Quantenpunktes (QP) festlegenden Schichtdicke h,
• Aufbringen einer oberen elektrisch isolierenden, diese Eigenschaft auch nach einem Ionendurchgang zeigenden Isolierschicht (IL₂) mit einer für Elektronen durchtunnelbaren Schichtdicke t₂,
• Bestrahlung des Schichtenpakets (LS) mit einem senkrecht dazu ausgerichteten Ionenstrahl (IB) aus schweren Ionen mit einer vorgegebenen Fluenz, die einen ausreichenden Abstand zwischen den einzelnen Durchgangsspuren (IT) der Ionen gewährleistet, und mit einer vorgegebenen Energie, die eine für eine in der Durchgangsspur (IT) jedes Ions erfolgende Umstrukturierung der elektrisch isolierenden Kohlenstoffschicht (DLC) mit diamantartiger Struktur in elektrisch leitenden Kohlenstoff (GLC) mit graphitartiger Struktur hinreichend hohe Energiedeposition gewährleistet, und
• Detektion der hergestellten Quantenpunkte aufgrund ihrer gegenüber der Kohlenstoffschicht (DLC) mit diamantartiger Struktur erhöhten elektrischen Leitfähigkeit.

9. Verfahren nach Anspruch 8 mit einer Bestrahlung des Schichtenpakets (LS) mit einem genau positionierbaren Mikro-Ionenstrahl (IB).

10. Verfahren nach Anspruch 8 oder 9 mit einer Zufuhr eines gasförmigen Zusatzstoffes, der die elektrische Isolationseigenschaft der Isolierschichten (IL₁, IL₂) erhaltende Eigenschaften aufweist, während des Aufbringens der Isolierschichten(IL₁, IL₂).

11. Verfahren nach Anspruch 10 mit einer Zufuhr von Wasserstoffgas (H₂), Chlor- oder Fluorgas als gasförmigem Zusatzstoff.

12. Verfahren nach einem der Ansprüche 8 bis 11 mit einem dem Aufbringen der Isolierschichten (IL₁, IL₂) vor- und nachgelagerten Aufbringen jeweils einer dickeren Kohlenstoffschicht (DLC₁, DLC₂) mit diamantartiger Struktur der Schichtdicken I₁, I₂

13. Verfahren nach Anspruch 12 mit einer äußeren elektrischen Kontaktierung des Quantenpunkts (QP).

14. Verfahren nach einem der Ansprüche 8 bis 13 mit einer n-fachen Wiederholung des Schichtenaufbaus (LS) zur Erzeugung von n vertikal in einer Linie angeordneten Quantenpunkten (QPₙ), wobei zwischen diesen zumindest eine Isolationsschicht ILₙ der Schichtdicke tₙ aufgebracht wird.

15. Anwendung eines Quantenpunkts (QP) aus elektrisch leitendem Kohlenstoff (GLC), insbesondere nach Anspruch 7, in einem Einzel-Elektron-Transistor (SET) mit einer elektrischen Kontaktierung der beiden Nanodrähte (NW₁, NW₂) im Quellen-Senken-Stromkreis (SDC) und mit einer ringförmigen Steuerelektrode (Gate), die konzentrisch zum Quantenpunkt (QP) auf der oberen Kohlenstoffschicht (DLC₂) mit diamantartiger Struktur angeordnet ist.

## Claims

1. Quantum point of electrically conducting carbon, **characterized by** an embedded structure as a cylindrical region having a graphite-like structure (GLC) in an electrically insulating carbon layer (DLC_{QP}) having a diamond-like structure that is disposed between two electrically insulating insulation layers (IL₁, IL₂) that exhibit this property even after the passage of an ion and that have layer thicknesses t₁, t₂ that electrons can tunnel through.

2. Quantum point according to Claim 1, **characterized by** insulation layers (IL₁, IL₂) having an included additive that achieves its electrical insulation properties.

3. Quantum point according to Claim 2, **characterized by** hydrogen (H), fluorine (F) or chlorine (C1) as additive intercalated in the insulation layers (IL₁, IL₂).

4. Quantum point according to Claim 2 or 3, **characterized by** insulation layers (IL₁, IL₂) of carbon having a diamond-like structure (DLC).

5. Quantum point according to any one of Claims 1 to 4, **characterized by** a structure having an electrically conducting substrate (SL).

6. Quantum point according to any one of Claims 1 to 5, **characterized by** a diameter d of 8 nm and a height h of 5 nm and by identical layer thicknesses t₁, t₂ of the insulation layers (IL₁, IL₂) likewise of 5 nm.

7. Quantum point according to Claim 6, **characterized by** an integrated structure comprising two electrically conducting nanowires (NW₁, NW₂) that are embedded as cylindrical regions in carbon having a graphite-like structure (GLC) and diameters d equal to that of the quantum point (QP) each embedded in a further electrically insulating carbon layer (DLC₁, DLC₂) having a diamond-like structure of layer thicknesses L₁ and L₂ above and below the two insulation layers (IL₁, IL₂).

8. Process for producing quantum points (QPs) of electrically conducting carbon, in particular according to any one of Claims 1 to 7, comprising the process steps of:
• deposition, on an electrically insulating substrate (SL), of a lower electrically insulating layer (IL₁) that exhibits this property even after the passage of an ion and that has a layer thickness t₁ that electrons can tunnel through,
• deposition of an electrically insulating carbon layer (DLC_{QP}) that has a diamond-like structure and a very low layer thickness h that determines the height of the quantum point (QP),
• deposition of an upper electrically insulating layer (IL₂) that exhibits this property even after the passage of an ion and that has a layer thickness t₂ that electrons can tunnel through,
• irradiation of the layer structure (LS) with an ion beam (IB), directed perpendicularly thereto, comprising heavy ions having a specified fluence that ensures an adequate spacing between the individual passage tracks (IT) of the ions and having a specified energy that ensures a sufficiently high energy deposition for a restructuring of the electrically insulating carbon layer (DLC) having a diamond-like structure, which restructuring takes place in the passage track (IT) of every ion, into electrically conducting carbon (GLC) having a graphite-like structure, and
• detection of the quantum points produced on the basis of their increased electrical conductivity with respect to the carbon layer (DLC) having a diamond-like structure.

9. Process according to Claim 8, comprising an irradiation of the layer structure (LS) with a precisely positionable ion micro-beam (IB)

10. Process according to Claim 8 or 9, comprising supplying a gaseous additive having properties that maintain the electrical insulation property of the insulation layers (IL₁, IL₂) during the application of the insulation layers (IL₁, IL₂).

11. Process according to Claim 10, comprising supplying hydrogen gas (H₂), chlorine gas or fluorine gas as gaseous additive.

12. Process according to any one of Claims 8 to 11, comprising the application of a thicker carbon layer (DLC₁, DLC₂) having a diamond-like structure of layer thicknesses (IL₁, IL₂), which deposition is respectively interposed before and after the deposition of the layer thicknesses (L₁, L₂).

13. Process according to Claim 12, comprising an external electrical contacting of the quantum point (QP).

14. Process according to any one of Claims 8 to 13, comprising an n-fold repetition of the layer structure (LS) for generating n quantum points (QPₙ) vertically disposed in a line, at least one insulation layer (ILₙ) of layer thickness tₙ being applied between said quantum points.

15. Use of a quantum point (QP) of electrically conducting carbon (GLC), in particular according to Claim 7, in a single-electron transistor (SET) having electrical contacting of the two nanowires (NW₁, NW₂) in the source-drain circuit (SDC) and having an annular control electrode (gate) that is concentrically disposed with respect to the quantum point (QP) on the upper carbon layer (DLC₂) having diamond-like structure.

## Revendications

1. Point quantique constitué de carbone électroconducteur,
**caractérisé par**
une structure logée sous forme de zone cylindrique ayant une structure de type graphite (GLC), dans une couche de carbone électriquement isolante (DLC_{QP}) à structure de type diamant qui, disposée entre deux couches électriquement isolantes (IL₁, IL₂) possédant cette propriété même après une traversée ionique, présente des épaisseurs de couches t1, t2 permettant le passage des électrons.

2. Point quantique selon la revendication 1,
**caractérisé par**
des couches isolantes (IL₁, IL₂) comprenant un additif intégré, qui obtient leur propriété d'isolation électrique.

3. Point quantique selon la revendication 2,
**caractérisé par**
de l'hydrogène (H), du fluor (F) ou du chlore (CL) en tant qu'additif intégré dans les couches isolantes (IL₁, IL₂).

4. Point quantique selon la revendication 2 ou 3,
**caractérisé par**
des couches isolantes (IL₁, IL₂) en carbone à structure de type diamant (DLC).

5. Point quantique selon l'une des revendications 1 à 4,
**caractérisé par**
une structure comprenant un substrat électroconducteur (SL).

6. Point quantique selon l'une des revendications 1 à 5,
**caractérisé par**
un diamètre d de 8 nm et une hauteur h de 5 nm, et des épaisseurs de couches t₁, t₂ identiques des couches isolantes (IL₁, IL₂), de 5 nm également.

7. Point quantique selon la revendication 6,
**caractérisé par**
une structure intégrée comprenant deux nanofils électroconducteurs (NW₁, NW₂) qui, en tant que zones cylindriques, sont intégrés dans le carbone à structure de type graphite (GLC) et, avec le même diamètre d que le point quantique (QP), sont intégrés au-dessus et en dessous des deux couches isolantes (IL₁, IL₂) dans respectivement une autre couche de carbone électriquement isolante (DLC₁, DLC₂) à structure de type diamant présentant une épaisseur de couche I₁, I₂.

8. Procédé de fabrication de points quantiques (QP) constitués de carbone électroconducteur, en particulier selon l'une des revendications 1 à 7, comprenant les étapes consistant à :
- appliquer une couche électriquement isolante (IL₁) possédant cette propriété même après une traversée ionique, ayant une épaisseur de couche t₁ permettant le passage des électrons, sur un substrat électroconducteur (SL),
- appliquer une couche de carbone électriquement isolante (DLC_{QP}) à structure de type diamant ayant une épaisseur de couche h très faible, qui détermine la hauteur du point quantique (QP),
- appliquer une couche électriquement isolante (IL₂), possédant cette propriété même après une traversée ionique, ayant une épaisseur de couche t₂ permettant le passage des électrons,
- irradier l'ensemble de couches (LS) avec un faisceau ionique (IB) orienté perpendiculairement à celui-ci, constitué d'ions lourds ayant une fluence prédéterminée, qui garantit une distance suffisante entre les chemins de traversée individuels (IT) des ions, et ayant une énergie prédéterminée, qui garantit un dépôt d'énergie suffisamment élevé pour une restructuration de la couche de carbone électriquement isolante (DLC) à structure de type diamant, s'effectuant dans le chemin de traversée (IT) de chaque ion, en carbone électroconducteur (GLC) à structure de type graphite, et
- détecter les points quantiques réalisés sur la base de leur conductivité électrique accrue par rapport à la couche de carbone (DLC) à structure de type diamant.

9. Procédé selon la revendication 8,
comprenant une irradiation de l'ensemble de couches (LS) avec un micro-faisceau ionique (IB) pouvant être positionné précisément.

10. Procédé selon la revendication 8 ou 9,
comprenant une amenée d'un additif gazeux qui présente des propriétés d'obtention de la propriété d'isolation électrique des couches isolantes (IL₁, IL₂), pendant l'application des couches isolantes (IL₁, IL₂).

11. Procédé selon la revendication 10,
comprenant une amenée d'hydrogène gazeux (H₂), de chlore ou de fluor gazeux, en tant qu'additif gazeux.

12. Procédé selon l'une des revendications 8 à 11,
comprenant une application, avant et après l'application des couches isolantes (IL₁, IL₂), de respectivement une couche de carbone plus épaisse (DLC₁, DLC₂) à structure de type diamant et présentant les épaisseurs de couches I₁, I₂.

13. Procédé selon la revendication 12,
comprenant une mise en contact électrique extérieure du point quantique (QP).

14. Procédé selon l'une des revendications 8 à 13,
comprenant une répétition à n reprises de la structure de couches (LS) pour générer n points quantiques (QPₙ) disposés verticalement sur une même ligne, et en appliquant entre ceux-ci au moins une couche isolante ILₙ, présentant l'épaisseur de couche tₙ.

15. Utilisation d'un point quantique (QP) constitué de carbone électroconducteur (GLC), en particulier selon la revendication 7, dans un transistor à un électron (SET), avec une mise en contact électrique des deux nanofils (NW₁, NW₂) dans le circuit d'augmentation-diminution (SDC) et avec une électrode annulaire (Gate), disposée de manière concentrique par rapport au point quantique (QP) sur la couche de carbone supérieure (DLC₂) à structure de type diamant.
